# EUROPEAN PATENT SPECIFICATION

(11) **EP 3 736 986 B1**
(45) Date of publication and mention of the grant of the patent: **14.07.2021**
(21) Application number: 20173545.3
(22) Date of filing: 07.05.2020
(51) Int. Cl.: H03K 17/96, H03K 17/94, H03K 17/955

(54) **ILLUMINATED SWITCH**
BELEUCHTETER SCHALTER
INTERRUPTEUR ÉCLAIRÉ

(30) Priority: 10.05.2019 EP 19173699; 05.07.2019 EP 19184642
(43) Date of publication of application: 11.11.2020
(73) Proprietor: Captron Electronic GmbH, 82140 Olching (DE)
(72) Inventor: ROGGE, Christian, 80337 München (DE); GEBHARD, Roman, 81541 München (DE)
(74) Representative: Lohr, Jöstingmeier & Partner

(56) References cited:
- WO-A1-2018/050542
- DE-A1- 10 218 294
- DE-B3- 10 304 985
- US-A1- 2008 067 052

## Description

### Field of the invention

The invention relates to a switch which is operated by a person or by bringing an object or a body part of a person in close proximity to a sensor or touching said sensor. Such a switch may be a capacitive sensor switch.

### Description of the related art

Switches and specifically capacitively operated sensor switches are often used for operating doors in railways and busses or other public transport systems, or for operating machines. The sensor switches are robust, maintenance-free, easy to use, and can be adapted to many different designs.

Sensor switches are often based on a capacitive sensor technology. A capacitive sensor may detect an approaching object and specifically an approaching body part, which may be a hand or a finger, by capacitively coupling an electrical signal to the object. An approaching object may be detected by an attenuation of the signal voltage or by an increasing signal current flowing through the object.

A switch which may be used for unlocking a door in a public transport is disclosed in US 2005/0231147 A1. Here, the switch is designed as an elongated bar which can easily be recognized due to its size.

A comparatively compact and disk-shaped device is disclosed in

DE 197 18 807 C1. Here, a capacitive sensor is mounted to one side of a public transport window. An indicator ring indicating the sensor area of the switch is mounted at the opposing side of the window. The switch is capacitively operated through the window.

DE 103 04 985 B3 discloses a rotary switch with a sensor surface attached to a mounting plate.

### Summary of the invention

The problem to be solved by the invention is to provide a switch with increased visibility. Such a switch may be recognized from a larger distance or under poor lighting conditions.

Solutions of the problem are described in the independent claims. The dependent claims relate to further improvements of the invention.

In an embodiment, a switch has a housing including a switching element which may be a mechanical switch. In another embodiment, the switching element includes a sensor which may further include a capacitive and/or optical sensor or which may cover a capacitive and/or optical sensor. Both embodiments may be combined with any of the features described herein. The switching element may be configured for detecting the presence of a body part. The sidewall may be configured to be insensitive against the presence of a body part.

The housing may have a top part and a bottom part. The top part includes a sensor surface on a top side and opposing thereto a mounting section. Between the sensor surface and the mounting section is a sidewall. The sidewall may have at least one rounded edge or a curved shape.

A switching element is arranged within or under the sensor surface. It may be covered by the sensor surface.

The mounting section may be configured to be mounted to a planar object like a plate which may be a glass plate or a metal structure. The surface of the mounting object may define a mounting plane.

The bottom part extends from the mounting section in a direction opposing to the sensor surface. The bottom part may be one part with the top part or mechanically separated thereof. The top part may be in a fixed spatial relationship to the bottom part. In an embodiment, the top part is not rotatable against the bottom part in an assembled working configuration. The bottom part may be screwed into the top part for assembly.

The sidewall further comprises at least one lighting window. A plurality of lighting windows may be provided. The lighting windows may be symmetrically arranged. For example, if there are two lighting windows, they may be arranged on opposing sides. If there are three lighting windows, these may be arranged under 120 degrees angles. Four lighting windows may be arranged under 90 degrees angles. Behind the at least one lighting window and within the housing is at least one light source which radiates light to the outside of the switch. The light sources may be arranged such that light is radiated on a surface on which the switch is mounted. This surface may be in the mounting plane. The surface may reflect the light and may provide a marking of the switch and/or a switch appearance which is larger than the switch itself. In addition, any other part of the housing, e.g. the switching element area may emit light. The emitted light may vary in color and intensity and over time.

The at least one lighting window may protect the light source from environmental influences and may provide a mechanical and/or electrical shield. It may be a lens or may comprise at least one lens or lens structure, for example a Fresnel-lens or parts thereof.

The housing has a mounting section, which is configured to be mounted to a surface. The top of the surface defines a mounting plane to which the housing (e.g. the switch) may be mounted. Preferably, the switching element has a planar surface which preferably is parallel to the mounting plane.

The housing may be a one piece housing with a preferably threaded shaft for holding the switching element. In another embodiment, the housing comprises a top part and a bottom part which may be mounted distant from each other. The top part may be in electrical and/or optical communication with the bottom part.

In an embodiment, the at least one light source is integrated into the switching element housing. It may also be integrated into an outer ring. In an embodiment, the switching element housing is a two-part embodiment, where the two parts may be mounted at different sides of a window. Here, the switching element and/or sensor electronics may be provided in a first part being on one side of the window, whereas the at least one light source is in another part, which may be an outer ring on the other side of the window. Also a light source for lighting the switching element may be provided. Any of the light sources may be LEDs, OLEDs or other light-emitting devices which are supplied by electrical energy which may be inductively or capacitively coupled from the first part. There may be a coil within the outer ring which is coupled to a coil in the first part to couple the electric energy between the two parts. Alternatively, the light may be emitted by at least one light source which may comprise a LED or other light-emitting components in the first part and guided for example by a lens system through the glass of the window into the second part like an outer ring where it is deflected to the at least one lighting window to the outside of the housing.

The light sources may have different and/or multiple colors which may indicate different states of the switch or different types or kinds of switches.

### Description of Drawings

In the following the invention will be described by way of example, without limitation of the general inventive concept, on examples of embodiment with reference to the drawings.
Figure 1 shows a top view of an embodiment.
Figure 2 shows a perspective view of an embodiment.
Figure 3 shows an embodiment mounted into a window.
Figure 4 shows a two-part embodiment.
Figure 5 shows an exemplary light distribution in a top view.
Figure 6 shows an exemplary light beam of the switch.

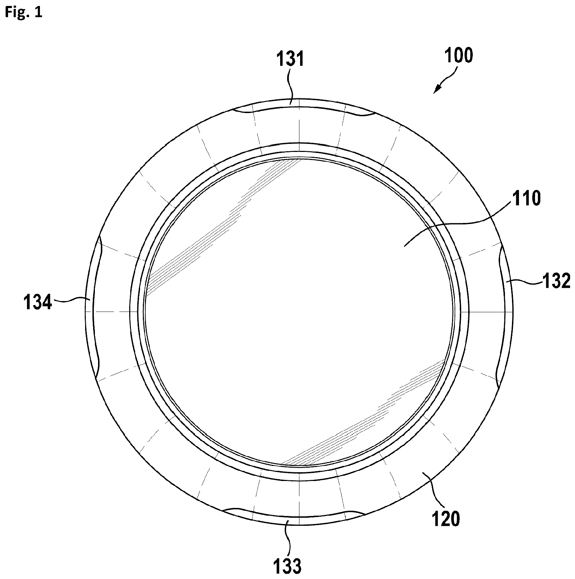

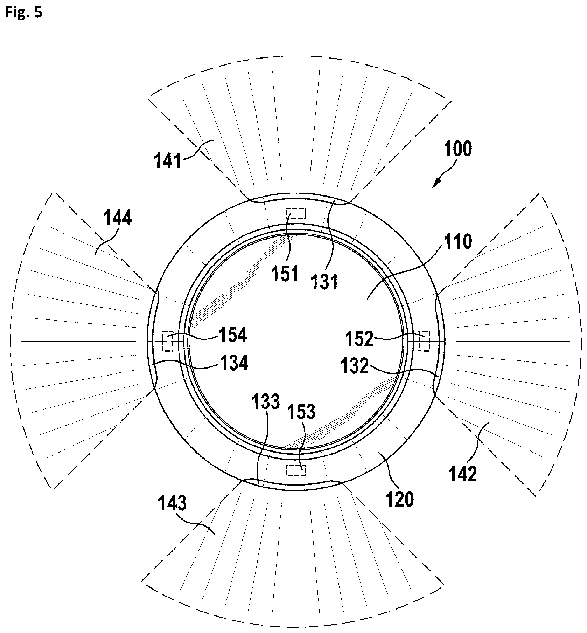

In Figure 1, a top view of an embodiment is shown. A switch 100 comprises a preferably planar switching element 110 or a planar sensor which is sensitive to an approaching object which may be a hand or a finger of a person. Preferably, the switching element 110 is a mechanical or electronic switching device or a a capacitive and/or optical proximity sensor. The switching element preferably has a planar surface. There may be an outer ring 120 surrounding the switching element 110. A plurality of lighting windows 131, 132, 133, 134 are provided circumferentially to the switching element and may be integrated into the outer ring 120. Preferably, the lighting windows are arranged symmetrically. In the embodiment shown herein, four lighting windows are provided which are arranged under angles of 90 degrees between adjacent windows. The windows have an elongated shape but they may have any other shape, like a circular shape or a rectangular slot, or any other shape which is suitable for providing a light output. Preferably, the lighting windows comprise a material which may conduct light of a suitable wavelength. Not shown in this Figure (but in Fig. 5) are light sources 151 - 154 which provide light which exits through the lighting windows. Preferably, at least one light source is provided within the switch and behind each of the lighting windows. The light sources may be individually controllable to generate various light patterns.

In an embodiment, the lighting windows and/or the sensor surface exclusively are configured to emit light. The outer ring, except for the windows, may include a non-light transmissive and/or a light absorbing material.

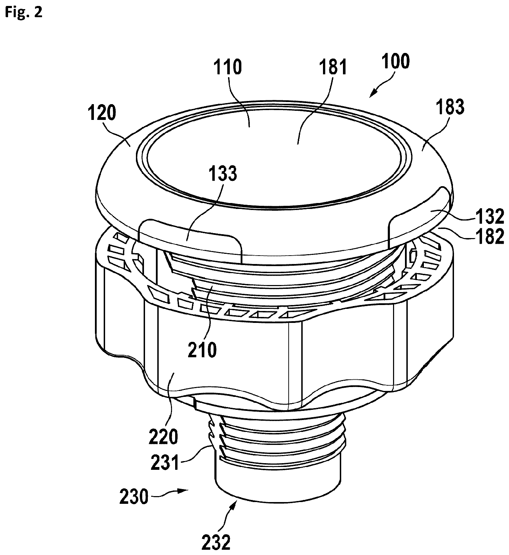

In Figure 2, a perspective view of an embodiment is shown. In addition to the top of the switch with sensor surface 181, sidewall 183, and mounting section 182, which may have a planar surface configured to be mounted to a surface which may be the top surface of a mounting plate, which will be shown in the next figure. The top surface also defining a mounting plane. The components of the bottom part 102 are also shown. There may be a shaft 210 which may comprise switching mechanics or electronics or further electronic devices required for capacitive and/or optical detection of an object in close proximity to the sensor 110. The shaft may have an outer thread which matches to a fastening nut 220. At the housing, there may also be a signal connector 230 for electrical connections providing power to the switch and coupling of a detection signal. The connector may have an outer thread 231 and connecting pins 232 which are on the bottom side in this embodiment and cannot be seen.

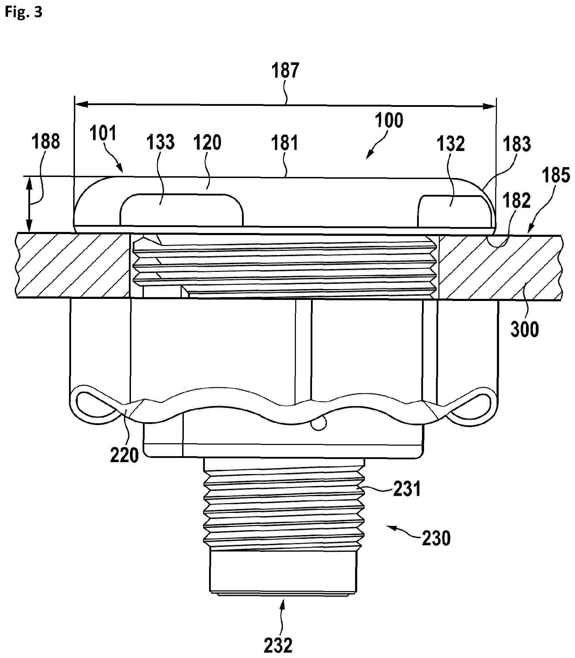

In Figure 3, an embodiment is shown, which is mounted into a plate 300 which may be a window or a glass plate. The top side of the plate 300 may be defining the mounting plane 185 which is in contact with the mounting section 182. It may also be a window comprising multiple parallel glass plates. The fastening nut 220 may be rotated to hold the switch within a hole of the window. The mounting plane is the top plane of the plate 300, which preferably corresponds to an under side of the top part of the housing containing the switching element.

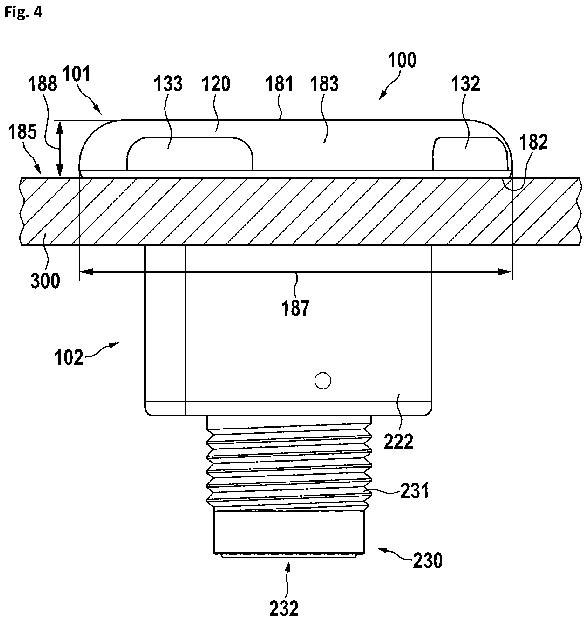

In Figure 4, a two-part embodiment is shown. Here, the switch 100 comprises a top part 101 which is attached on one side of the plate 300, which may be a window, and a bottom part 102 which is mounted opposing to the top part 101 on the other side of the plate 300, which may be a window. The advantage of this embodiment is that there is no hole required in the window. The disadvantage is that coupling of electrical signals and/or sensing of an object may be somewhat more complicated due to the higher coupling distance through the plate, which may be a window, and coupling of light or electrical power for light sources from the second part 102 to the first part 101 may require additional effort as disclosed above. The mounting plane is the top plane of the plate 300, which preferably corresponds to an under side of the top component 101.

The top part 101 may have a width or a diameter 187 which is larger than its height 188. The ratio width/height may be less than one of 10, 8, 6, 5, 4, 3, 2. The top part 101 may have a circular shape. It may have a diameter 187 which is larger than its height 188. The ratio diameter/height may be less than one of 10, 8, 6, 5, 4, 3, 2.

In Figure 5, an exemplary light distribution of the switch is shown in a top view. In addition, here only for demonstration purposes, the light sources 151, 152, 153, 154 are indicated. They cannot be seen, as they are embedded into the outer ring 120 of the switch. The light sources radiate light through the lighting windows 131, 132, 133, 134 and generate light beams 141, 142, 143, 144. These light beams are preferably directed under a small angle to the surface on which the switch is mounted, as will be shown in the next Figure.

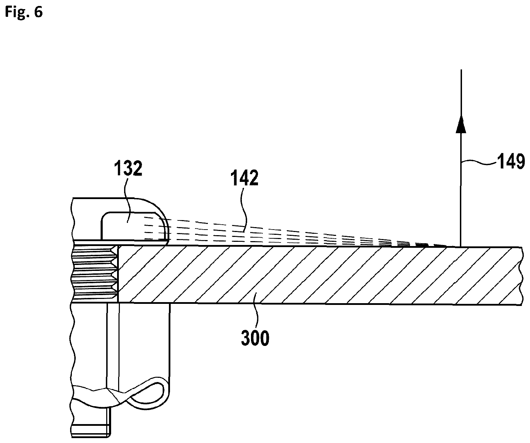

In Figure 6, an exemplary light beam of the switch is shown. Here, light emitted through the lighting window 132 forming a light beam 142 is directed under a small angle towards the plate 300 which may be a window or a metal plate. The light is reflected by the plate 300 and may be seen by a person, such as a person operating the switch. The best results are provided if the surface of the plate is light reflecting such that the light emitted through the window 132 is emitted in a direction orthogonal to the plate, such as indicated by arrow 149.

### List of reference numerals

- 100: switch
- 101: top part of housing
- 102: bottom part of housing
- 110: switching element
- 120: outer ring
- 131 - 134: lighting windows
- 141 - 144: light beams
- 149: direction of reflected light
- 151 - 154: light sources
- 181: sensor surface
- 182: mounting section
- 183: sidewall
- 185: mounting plane
- 187: width or diameter
- 188: height
- 210: shaft
- 220: fastening nut
- 230: signal connector
- 231: outer thread
- 232: connecting pins
- 300: mounting plate

## Claims

1. A switch (100) comprising a housing further comprising a disc shaped top part (101) and a bottom part (102),
the top part (101) comprises a sensor surface (181) on a top side, opposing thereto a mounting section (182), and a sidewall (183) between the sensor surface (181) and the mounting section (182),
a switching element (110) is arranged within or under the sensor surface (181),
the mounting section (182) is configured to be mounted to a planar object (300) having a top surface which defines a mounting plane (185), and the bottom part (102) extends from the mounting section (182), **characterized in, that**
the sidewall (183) comprises at least one lighting window (131 - 134), the at least one lighting window (131 - 134) covering at least one light source (151 - 154) in the housing providing a light beam (141-144) in a plane parallel to the mounting plane or under an angle directed to the mounting plane.

2. A switch (100) according to claim 1,
wherein
the switch comprises a one-piece housing including a switching element (110) and a shaft (210).

3. A switch (100) according to claim 2,
wherein
the shaft (210) has an outer thread (231).

4. A switch (100) according to claim 1,
wherein
the switch comprises a housing comprising a top part (101) and a bottom part (102) which may be mounted vertically distant from but opposite each other.

5. A switch (100) according to claim 4,
wherein
the top part (101) is in electrical and/or optical communication with the bottom part (102).

6. A switch (100) according to any of the previous claims,
wherein
the switching element (110) comprises a light source for lighting the switching element (110).

7. A switch (100) according to any of the previous claims,
wherein
at least one light source is a LED or an OLED.

8. A switch (100) according to any of the previous claims,
wherein
the switch (100) is a sensor switch and wherein the switching element is a capacitive and/or optical sensor (110) for detecting the presence of a body part and/or the sidewall is configured to be insensitive against the presence of a body part.

9. A switch (100) according to any of the previous claims,
wherein
the sensor surface (181) is parallel to the mounting section (182).

10. A switch (100) according to any of the previous claims,
wherein
the sidewall (183) has at least one rounded edge.

11. A switch (100) according to any of the previous claims,
wherein
the disc shaped top part (101) has a width (187) larger than its height (188).

12. A switch (100) according to any of the previous claims,
wherein
exclusively the lighting windows (131 - 134) and/or the sensor surface (181) are configured to emit light.

13. A switch (100) according to any of the previous claims,
wherein
the top part (101) is not rotatable against the bottom part (102) in an assembled working configuration.

## Patentansprüche

1. Ein Schalter (100), umfassend ein Gehäuse, das weiterhin einen scheibenförmigen oberen Teil (101) und einen unteren Teil (102) umfasst, wobei der obere Teil (101) eine Sensoroberfläche (181) auf einer Oberseite aufweist, dem gegenüberliegend einen Montageabschnitt (182), und eine Seitenwand (183) zwischen der Sensoroberfläche (181) und dem Montageabschnitt (182) umfasst,
ein Schaltelement (110) innerhalb oder unter der Sensoroberfläche (181) angeordnet ist,
der Montageabschnitt (182) konfiguriert ist, um angebracht zu werden an einem ebenen Objekt (300) mit einer oberen Oberfläche, welche eine Montageebene (185) definiert, und der untere Teil (102) sich von dem Montageabschnitt (182) erstreckt,
**dadurch gekennzeichnet, dass**
die Seitenwand (183) mindestens ein Beleuchtungsfenster (131 - 134) umfasst, wobei das mindestens eine Beleuchtungsfenster (131 - 134) mindestens eine Lichtquelle (151 - 154) im Gehäuse abdeckt, welche einen Lichtstrahl (141 - 144) in einer Ebene parallel zur Montageebene oder unter einem Winkel zur Montageebene gerichtet bereitstellt.

2. Ein Schalter (100) nach Anspruch 1,
wobei der Schalter ein einteiliges Gehäuse mit einem Schaltelement (110) und einem Schaft (210) umfasst.

3. Ein Schalter (100) nach Anspruch 2,
wobei der Schaft (210) ein Außengewinde (231) hat.

4. Ein Schalter (100) nach Anspruch 1,
wobei der Schalter ein Gehäuse umfasst, welches einen oberen Teil (101) und einen unteren Teil (102) umfasst, die senkrecht voneinander beabstandet aber einander gegenüberliegend montiert sein können.

5. Ein Schalter (100) nach Anspruch 4,
wobei der obere Teil (101) in elektrischer und/oder optischer Kommunikation mit dem unteren Teil (102) steht.

6. Ein Schalter (100) gemäß einem der vorhergehenden Ansprüche,
wobei das Schaltelement (110) eine Lichtquelle zum Beleuchten des Schaltelements (110) umfasst.

7. Ein Schalter (100) gemäß einem der vorhergehenden Ansprüche,
wobei mindestens eine Lichtquelle eine LED oder eine OLED ist.

8. Ein Schalter (100) gemäß einem der vorhergehenden Ansprüche,
wobei der Schalter (100) ein Sensorschalter ist, und wobei das Schaltelement ein kapazitiver und/oder optischer Sensor (110) zum Erfassen des Vorhandenseins eines Körperteils ist und/oder die Seitenwand so konfiguriert ist, dass sie gegenüber dem Vorhandensein eines Körperteils unempfindlich ist.

9. Ein Schalter (100) gemäß einem der vorhergehenden Ansprüche,
wobei die Sensoroberfläche (181) parallel zum Montageabschnitt (182) verläuft.

10. Ein Schalter (100) gemäß einem der vorhergehenden Ansprüche,
wobei die Seitenwand (183) hat mindestens eine abgerundete Kante hat.

11. Ein Schalter (100) gemäß einem der vorhergehenden Ansprüche,
wobei der scheibenförmige obere Teil (101) eine Breite (187) hat, die größer als seine Höhe (188) ist.

12. Ein Schalter (100) gemäß einem der vorhergehenden Ansprüche,
wobei ausschließlich die Beleuchtungsfenster (131 - 134) und/oder die Sensoroberfläche (181) so konfiguriert sind, dass sie Licht emittieren.

13. Ein Schalter (100) gemäß einem der vorhergehenden Ansprüche,
wobei der obere Teil (101) in einer zusammengebauten Arbeitskonfiguration nicht gegen den unteren Teil (102) drehbar ist.

## Revendications

1. Interrupteur (100) comprenant un boîtier comprenant en outre une partie de dessus (101) en forme de disque et une partie de dessous (102),
la partie de dessus (101) comprend une surface de capteur (181) sur un côté de dessus, opposée à celle-ci une section de montage (182), et une paroi latérale (183) entre la surface de capteur (181) et la section de montage (182),
un élément de commutation (110) est agencé au sein ou en dessous de la surface de capteur (181),
la section de montage (182) est configurée pour être montée sur un objet plan (300) ayant une surface de dessus qui définit un plan de montage (185), et
la partie de dessous (102) s'étend depuis la section de montage (182),
**caractérisé en ce que**
la paroi latérale (183) comprend au moins une fenêtre d'éclairage (131 à 134), l'au moins une fenêtre d'éclairage (131 à 134) couvrant au moins une source de lumière (151 à 154) dans le boîtier fournissant un faisceau de lumière (141 à 144) dans un plan parallèle au plan de montage ou en dessous d'un angle dirigé vers le plan de montage.

2. Interrupteur (100) selon la revendication 1,
dans lequel
l'interrupteur comprend un boîtier en une pièce comportant un élément de commutation (110) et une tige (210).

3. Interrupteur (100) selon la revendication 2,
dans lequel
la tige (210) possède un filet externe (231).

4. Interrupteur (100) selon la revendication 1,
dans lequel
l'interrupteur comprend un boîtier comprenant une partie de dessus (101) et une partie de dessous (102) qui peuvent être montées verticalement à distance, mais opposées l'une à l'autre.

5. Interrupteur (100) selon la revendication 4,
dans lequel
la partie de dessus (101) est en communication électrique et/ou optique avec la partie de dessous (102).

6. Interrupteur (100) selon l'une quelconque des revendications précédentes,
dans lequel
l'élément de commutation (110) comprend une source de lumière pour éclairer l'élément de commutation (110).

7. Interrupteur (100) selon l'une quelconque des revendications précédentes,
dans lequel
au moins une source de lumière est une DEL ou une DELO.

8. Interrupteur (100) selon l'une quelconque des revendications précédentes,
dans lequel
l'interrupteur (100) est un interrupteur à capteur et dans lequel l'élément de commutation est un capteur capacitif et/ou optique (110) pour détecter la présence d'une partie corporelle et/ou la paroi latérale est configurée pour être insensible à la présence d'une partie corporelle.

9. Interrupteur (100) selon l'une quelconque des revendications précédentes,
dans lequel
la surface de capteur (181) est parallèle à la section de montage (182).

10. Interrupteur (100) selon l'une quelconque des revendications précédentes,
dans lequel
la paroi latérale (183) possède au moins un bord arrondi.

11. Interrupteur (100) selon l'une quelconque des revendications précédentes,
dans lequel
la partie de dessus (101) en forme de disque possède une largeur (187) plus grande que sa hauteur (188).

12. Interrupteur (100) selon l'une quelconque des revendications précédentes,
dans lequel
les fenêtres d'éclairage (131 à 134) et/ou la surface de capteur (181) exclusivement sont configurées pour émettre de la lumière.

13. Interrupteur (100) selon l'une quelconque des revendications précédentes,
dans lequel
la partie de dessus (101) n'est pas rotative contre la partie de dessous (102) dans une configuration de fonctionnement assemblée.
